# EUROPEAN PATENT SPECIFICATION

(11) **EP 0 947 050 B1**
(45) Date of publication and mention of the grant of the patent: **02.05.2003**
(21) Application number: 97950004.8
(22) Date of filing: 22.12.1997
(51) Int. Cl.: H03L 7/085, H04J 3/07, H04L 7/033

(54) **A DIGITAL PHASE-LOCKED LOOP AND A METHOD OF CONTROLLING IT, AS WELL AS A METHOD AND RECEIVER CIRCUIT FOR DESYNCHRONIZATION IN A DIGITAL TRANSMISSION SYSTEM**
DIGITALE PHASENREGELSCHLEIFE UND VERFAHREN ZU IHRER STEUERUNG SOWIE METHODE UND EMPFANGSSCHALTUNG ZUR DESYNCHRONISATION IN EINEM DIGITALEN ÜBERTRAGUNGSSYSTEM
BOUCLE NUMERIQUE A PHASE ASSERVIE ET SON PROCEDE DE COMMANDE, ET PROCEDE ET CIRCUIT DE RECEPTION POUR DESYNCHRONISATION DANS UN SYSTEME DE TRANSMISSION NUMERIQUE

(30) Priority: 23.12.1996 DK 150796
(43) Date of publication of application: 06.10.1999
(73) Proprietor: TELLABS DENMARK A/S, 2750 Ballerup (DK)
(72) Inventor: THOMSEN, Per, H., DK-2000 Frederiksberg (DK)
(74) Representative: Boesen, Johnny Peder
(86) International application number: DK9700594
(87) International publication number: WO98028849

(56) References cited:
- US-A- 4 947 407
- US-A- 5 311 511
- US-A- 5 479 457
- US-A- 5 563 891

## Description

The invention relates to a digital phase-locked loop comprising a numerically controlled oscillator which is adapted to generate a clock signal by dividing a system clock frequency by a factor determined by a control word, and a phase detector which is adapted to generate the control word in response to a phase difference between the clock signal and an external reference signal, so that the control word assumes a nominal value when the phase difference is numerically smaller than a value given in advance, and may assume one or more other values when the phase difference is numerically greater than the given value. The invention also relates to a method of controlling such a digital phase-locked loop.

Finally, the invention relates to a method of desynchronization in a receiver in a digital transmission system, wherein justification is performed by adding or removing one or more bits, as needed, in the transmitted bit flow on the transmission side when placing e.g. telephone calls in the transmission system and wherein the effect of the added and removed bits is smoothed in the receiver in the desynchronization, and wherein a digital phase-locked loop is used, as well as to a receiver circuit for use in this connection.

Today, digital phase-locked loops are used in large numbers in digital circuits. An example of the use is in connection with pointer adjustments in digitally built telecommunications networks, such as e.g. SDH networks (Synchronous Digital Hierarchy). This type of network is based on one or more extremely stable clock signals. Notwithstanding that the network includes extremely stable references, differences between phase and frequency of the references may arise, e.g. as a consequence of temperature effects on the communications channels between the nodes of the network. The network elements in such a communications network must be capable of tolerating these variations in phase and frequency without data in the form of communications signals being lost. This may be ensured by making pointer adjustments comprising adding or removing a number of bits or bytes in the data flow.

A frame structure is used when transmitting data, so that data in the form of e.g. telephone calls have a special position in the frame, while signals for controlling and monitoring the communication have another position in the frame. These signals are called overhead signals. The structure of these overhead signals reserves a plurality of bytes, e.g. three bytes, which may be used in connection with pointer adjustments and therefore do not contain any other information. It is possible to fill some of these bytes with data proper in a transmitter in the network when additional data have to be added (negative pointer adjustment), or to insert one or more empty bytes among the data proper when data are to be removed (positive pointer adjustment), in order to compensate for the mentioned deviations in phase and frequency with respect to the other elements in the network.

When this form of compensation is used, the transferred signal will receive jitter. Jitter means that a digital signal briefly differs from its correct position in time, or in other words a phase jump is imparted to it.

Pointer adjustments may also occur in SDH network elements when a PDH system (Plesiochronous Digital Hierarchy) is to be inserted into the SDH frame structure. A frame structure frequently used for transport between the network elements in an SDH system is an STM-1 frame which has a bit frequency of 155 Mbits/sec and can transport 63 TU-12 signals, each having a bit frequency of 2 Mbits/sec. The STM-1 frames are transmitted with 8 kHz.

In the network elements where these compensated (pointer adjusted) communications signals are received, e.g. in demultiplexers, it will be attempted to neutralize the effect of these adjustments by low-pass filtering the phase jumps which they have caused. This may be done e.g. by inputting the incoming data in a buffer with a (jitter) clock signal derived from the data signal and then outputting them again with a stabilized clock signal, which has been formed by feeding the jitter clock signal through a phase-locked loop. This corresponds to low-pass filtering of the jitter effect, the phase variations between the incoming and the stabilized clock signal being low-pass filtered in the phase-locked loop.

Today, such a circuit is typically implemented on a special customer-designed integrated circuit, e.g. an ASIC circuit. This means that, as far as possible, all subcircuits must be realized without the use of analog components, and the phase-locked loop will therefore preferably be implemented as a digital phase-locked loop (DPLL). A digital phase-locked loop is usually based on a numerically controlled oscillator (NCO) and has the drawback with respect to an analog phase-locked loop that the frequency of the emitted clock signal cannot vary continuously, but can only switch between a plurality of discrete values, as the clock signal is typically generated by division in discrete stages of an internal clock frequency for the customer-designed circuit.

This means that when the phase-locked loop adjusts e.g. in order to be able to compensate for a pointer adjustment, the frequency of the NCO is changed to another discrete value, which is then used until the effect has been compensated, following which the NCO returns to its original frequency. These frequency jumps are unfortunate for the following circuits, and it would therefore be desirable if the size of the frequency jumps could be reduced, while then spending more time on compensating the effect of a pointer adjustment.

Such a circuit in which jitter is compensated by means of a digital phase-locked loop is known from US 5 479 457. The frequency of the numerically controlled oscillator can also here only switch between a number of discrete values and also this circuit does, therefore, not avoid the unwanted frequency jumps.

It is known from US Patent 5 245 636 to reduce jitter caused by pointer adjustments by dividing each phase jump into a plurality of smaller phase jumps, which are then smoothed separately. Although this solution gives a certain reduction in the effect of the actual phase jump, it does not change the fact that when a digital phase-locked loop is used, a jump will occur between discrete frequencies.

In a different context (i.e. generation of a clock signal synchronized to a signal that is modulated by ASK) it is known from US 4 947 407 to let an NCO in a partly digital phase-locked loop switch between two discrete frequencies controlled by a pulse signal whose duty cycle is regulated by means of an analog feedback circuit. This known circuit is able to regulate the output frequency substantially continously. However, this principle cannot be used in a purely digital phase-locked loop in which the numerically controlled oscillator is controlled by a control word as it is the case in the present invention.

Accordingly, an object of the invention is to provide a digital phase-locked loop of the type defined in the opening paragraph where the size of said frequency jumps may be reduced considerably, and where the loop may simultaneously be implemented exclusively by using digital components.

This is achieved according to the invention in that the loop comprises means which, when the phase difference is numerically greater than the given -value, are capable of modulating the control word so that said word assumes one of the one or more other values in subperiods, while it assumes the nominal value in intermediate periods.

Thus, by just emitting the control word which means that the numerically controlled oscillator is to run with another frequency than the nominal one for a fraction of the time, the oscillator will also just use the higher or lower frequency for a fraction of the time, while it will still use the nominal frequency for the rest of the time. This means in practice that the oscillator will emit a frequency which differs significantly less from the nominal frequency than the difference between two discrete adjacent frequencies.

As stated in claim 2, in addition to the nominal value, the control word may expediently assume at least one other value when the phase difference indicates that the clock signal frequency is lower than the reference signal frequency, and at least one other value when the clock signal frequency is higher than the reference signal frequency.

A particularly expedient embodiment is obtained when, as stated in claim 3, the control word may assume two values (+1, +2) when the phase difference indicates that the clock signal frequency is lower than the reference signal frequency, and two values (-1, -2) when the clock signal frequency is higher than the reference signal frequency, and when the modulation means are adapted to modulate the control word only when it assumes the values (+1, -1) which correspond to the numerically smallest phase difference. This means that minor deviations may be smoothed slowly, while great phase differences, which just occur very rarely, may be smoothed quickly, since, otherwise, e.g. data would tend to be lost.

When, like in claim 4, the modulation means are adapted to modulate the control word with a pulse signal which has a fixed cycle time and a variable pulse width, a very flexible control is achieved. Further, as stated in claim 5, the digital phase-locked loop may comprise means for controlling the pulse width in response to said phase difference. This allows the size of the resulting frequency jumps to be controlled in response to the phase difference, so that a somewhat greater phase difference may be adjusted relatively more quickly than a smaller one.

As mentioned, the invention also relates to a method of controlling such a digital phase-locked loop, wherein the control word is modulated as described above. In the method, too, this results in the generation of a frequency in practice which differs considerably less from the nominal frequency than the difference between two discrete adjacent frequencies. This method is defined in claim 6.

The invention moreover relates to a method of desynchronization in a receiver in a digital transmission system, wherein the control word in a digital phase-locked loop is modulated as described above, and to a corresponding receiver circuit. The method is defined in claim 7, and the receiver circuit in claim 8. When, in this connection, the control word is modulated as described above, it is ensured that pointer adjustments in e.g. an SDH system may be smoothed without the great frequency jumps which a digital phase-locked loop would otherwise involve, and which might cause loss of data.

In an expedient embodiment, which is defined in claim 9, the receiver circuit comprises a buffer circuit adapted such that the received data signals may be input in the buffer circuit by means of the reference clock signal and be output again by means of said clock signal. The phase detector of the digital phase locked loop is formed by the buffer circuit, and the number of data signals, which are input in but not yet output from the buffer circuit, are used as an indication of the phase difference between said clock signal and the reference clock signal. This obviates the need for a phase detector proper for comparing the two clock signals.

In connection with an SDH system the buffer circuit may be constructed as ring buffer and be adapted to store 12 bytes, as stated in claim 10.

Claims 11-14 define expedient embodiments which correspond to those described above for the digital phase-locked loop.

As stated in claim 15, the receiver circuit may comprise means to generate the control word in response to a highest value of the number of data signals which are input but not output from the buffer circuit, measured over a period of time. This ensures stable control, since fluctuations caused by brief changes in the filling degree of the buffer are obviated.

As stated in claim 16, for use in an SDH system the numerically controlled oscillator may expediently be adapted to generate a clock signal whose nominal frequency is 2.112 MHz.

The invention will now be described more fully below with reference to the drawing, in which
fig. 1 shows a circuit in which the invention may be applied,
fig. 2 shows an alternative embodiment of the circuit of fig. 1,
fig. 3 shows how a filter may be constructed according to the invention, and
fig. 4 shows an example of a structure of a detector circuit for use in connection with the invention.

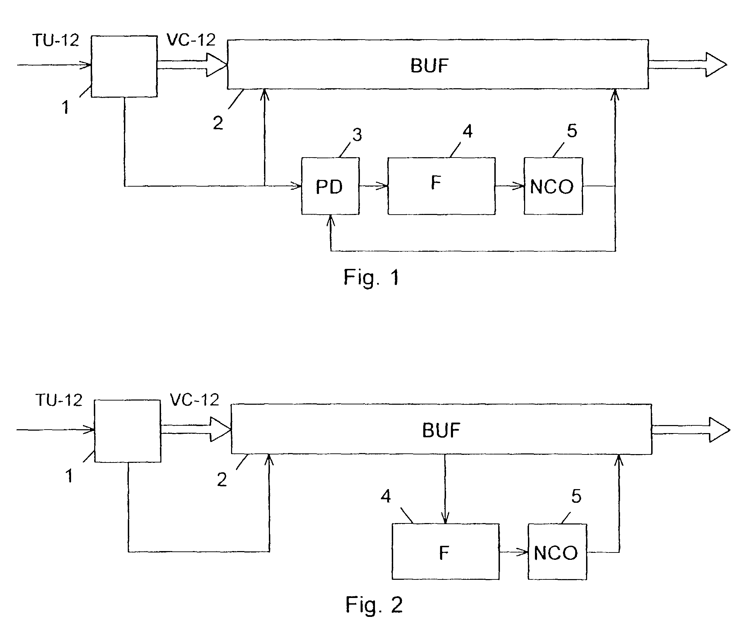

Fig. 1 shows a circuit in which the invention may be applied in connection with unpacking and desynchronization of data signals in an SDH system. The circuit receives data signals, which may e.g. be so-called TU-12 signals. In a demapping circuit 1, the TU-12 signals are unpacked to VC-12 signals, with concurrent separation of overhead signals from the data signals proper. Further, in the circuit 1, a clock signal is generated from the incoming data, a clock pulse being generated in principle for each data byte in the unpacked VC-12 signals. If pointer adjustments have been made on the transmitter side, this will appear from the overhead signals, and, depending on this, the circuit 1 may therefore add or remove clock pulses in the generated clock signal, which therefore becomes irregular as the clock frequency will vary in step with the addition or removal of clock pulses. This frequency variation is called jitter. As will be described below, the circuit 1 may also be adapted to generate a multiframe reference signal of 2 kHz.

The unpacked VC-12 signals are input via a data bus in a buffer 2 by means of the clock signal generated in the circuit 1 and possibly vitiated by jitter, so that the input will take place at an uneven rate depending on pointer adjustments, if any. The data buffer 2 may be constructed as a ring buffer and may e.g. be of 12 bytes.

To smooth the uneven rate, the jitter clock signal is passed through a phase-locked loop, which, as shown in fig. 1, may consist of a phase detector 3, a filter 4 and a numerically controlled oscillator 5. As a result, a new clock signal appears on the output of the numerically controlled oscillator 5, having an approximately constant frequency which corresponds to the mean frequency of the jitter clock signal, and it is in connection with the generation of this smoothed clock signal that the invention may be applied.

Smoothing of the uneven rate of the data signals then takes place in that the data input in the buffer 2 are output from the buffer again by means of the smoothed clock signal. In the case of VC-12 signals, the smoothed clock signal will typically have a frequency of 264 kHz; but since the signals are usually to be processed bitwise subsequently, the output signal from the numerically controlled oscillator 5 will have a frequency eight times as high, viz. 2.112 MHz, which will then merely be divided by a factor of 8 before being used for output of data from the buffer 2. Then, as mentioned, the data signals may be further processed in subsequent circuits; but this is of no importance to the invention and will therefore not be described more fully.

The phase detector 3 measures the phase difference between the jitter clock signal and the smoothed clock signal, following which a control word, which controls the numerically controlled oscillator 5, is generated via the filter 4. The oscillator 5 may be implemented as a programmable divider which, in response to the control word, is capable of dividing a system clock signal, which has a higher frequency, by a factor determined by the control word. The control word may e.g. assume the three values {-1, 0, +1}. If a system clock signal of 19.44 MHz is used, the oscillator may be adapted to divide by a factor of 9.204545 corresponding to the desired frequency of 2.112 MHz when the control word is 0. When the control word is -1, because the phase detector 3 has detected that the smoothed clock frequency is greater than the mean frequency of the jitter clock signal, the oscillator may divide by a factor of 9.204611 corresponding to a frequency of 2.111985 MHz. When the control word is +1, the oscillator may correspondingly divide by a factor of 9.204482 corresponding to a frequency of 2.112015 MHz.

Alternatively, the control word may assume the values {-2, -1, 0, +1, +2}, said values -2 and +2 giving frequencies which differ more from the nominal frequency, and being used when the phase detector detects greater deviations from the mean frequency of the jitter clock signal. This may occur e.g. if frequent and great pointer adjustments are made because of errors in the system.

As mentioned above, the buffer 2 may e.g. consist of 12 storage locations or bytes, each of the size of 8 bits and indexed by an address. The difference between the address to which input is performed and the address from which output is performed, indicates the filling degree of the buffer. This value of the filling degree is an indication of the phase difference between the two clock signals, and instead of comparing these in the phase detector 3, it will therefore suffice to feed a signal which indicates the filling degree of the buffer 2 from the buffer to the filter 4. It may thus be said that the phase detector of the phase-locked loop is formed by the buffer 2. This is shown in fig. 2, which corresponds to fig. 1 in other respects.

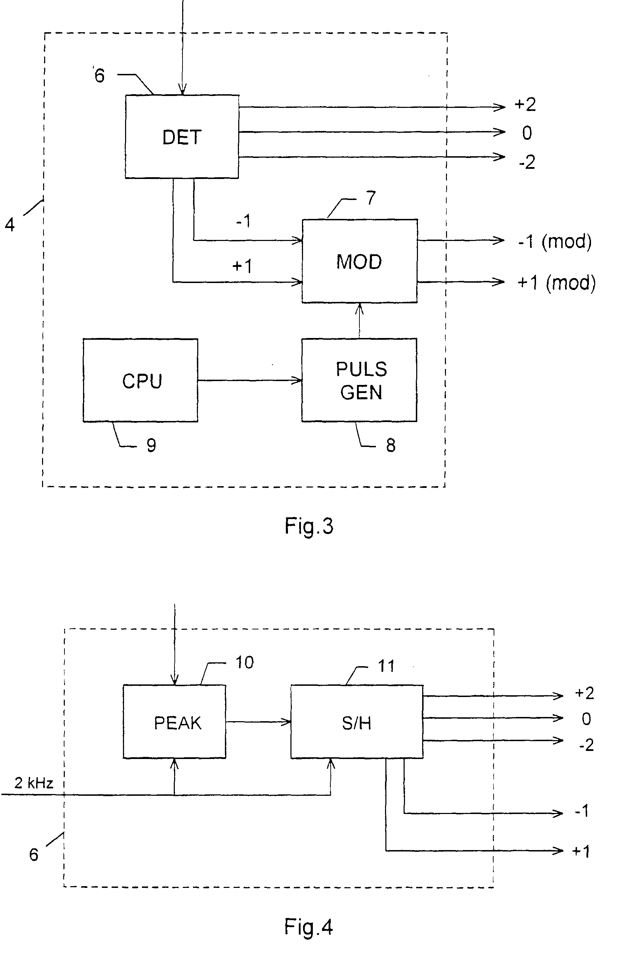

As mentioned before, it may be desirable to be able to adjust the frequency of the numerically controlled oscillator 5 in considerably smaller jumps than is possible with the above-mentioned frequencies. This is possible if the filter 4 is formed as shown in fig. 3.

The value indicating the filling degree of the buffer 2 is fed to a detector circuit 6. As the buffer contains 12 bytes, the filling degree may assume the values 0-12. The value 12 indicates that the buffer is completely filled, while the value 0 correspondingly indicates that the buffer is empty. It is intended that the filling degree is in the middle of the range, and the values 5-7 are therefore regarded as being the normal ones. At these values, the detector circuit 6 will emit the control word 0 to indicate that the oscillator 5 may continue with a frequency of 2.112 MHz.

The filling degree of the buffer will typically be changed when pointer adjustments occur, and the value will be changed by 1 for each adjustment of one byte. If the buffer is close to being filled, corresponding to the values 10-12, or close to being empty, corresponding to the values 0-2, fast adjustment must be performed, and the detector circuit 6 will emit the control words -2 or +2 indicating that the numerically controlled oscillator 5 is to have either a smallest or a greatest frequency in order to bring the filling degree of the buffer back to a level about a mean filling degree as quickly as possible. In this case, a great frequency jump must be accepted, since, otherwise, data will be lost owing to overflow in the buffer. So strong pointer adjustments, however, will just occur very rarely.

Normally occurring pointer adjustments, however, will maximally cause the filling degree to assume the values 3, 4 or 8, 9, and there is thus no immediate risk of overflow in the buffer 2, for which reason very fast adjustment of the filling degree is not needed. The control word emitted by the detector circuit 6 will be -1 or +1 in this case; but instead of feeding it directly forwards to the oscillator 5, as described before, it is passed to a modulator 7 in which it may be modulated with a square wave signal from a pulse generator 8. The pulse generator 8 is controlled from a processor 9. The square wave signal has a fixed cycle time of e.g. 256 msec, whereas the pulse width is variable in steps of e.g. 1 msec. The square wave signal from the pulse generator 8 is applied to the modulation input of the modulator and thus determines the control word emitted. When the square wave signal is high, the control word -1 or +1 is emitted, while the control word 0 is emitted instead in the pauses between the pulses. This means that the control word -1 or +1 will just be emitted for a fraction of the time, and the oscillator 5 will therefore use the higher or lower frequency also just for a fraction of the time, while it will continue to use the nominal frequency for the rest of the time.

This means in practice that the oscillator will emit a frequency which differs considerably less from the nominal frequency than the previously mentioned difference between two adjacent frequencies. For example, the frequency at the control word +1 may be selected here in jumps of 1/256 of the difference between 2.111985 MHz and 2.112000 MHz. When the resulting frequency differs less from the nominal one than before, the smoothing of a pointer adjustment will take a longer time than before, of course; but since pointer adjustments normally do not occur very frequently, this will actually be quite expedient. If, nevertheless, several adjustments should take place immediately after one another, the detector circuit 6 will emit the control word -2 or +2, as described before, and thereby provide for fast adjustment, thereby obviating overflow of the buffer.

The pulse width of the square wave signal emitted by the pulse generator 8 is controlled from a processor 9, as mentioned. The processor may merely be adapted to select a specific pulse width for each filling degree. For example, the pulse width may be selected at 1 msec at the filling degree 4 or 8 to ensure that the compensation is extended over the greatest possible length of time, while a somewhat greater pulse width may be selected at the filling degree 3 or 9, thereby providing a somewhat faster adjustment toward the middle values. However, the processor 9 may also receive the overhead signals which are unpacked in the demapping circuit 1, and thereby select an expedient pulse width in each individual situation on the basis of these signals as well as the filling degree.

Fig. 4 shows an example of how the detector circuit 6 may be constructed. It consists of a peak value detector 10 and a sample-and-hold circuit 11. The peak value detector 10 receives the signal which indicates the filling degree of the buffer 2, and it moreover receives a multiframe reference signal from the demapping circuit 1. The detector 10 detects the highest value of the filling degree over a period of the multiframe reference signal, and this value is sampled by the multiframe reference signal in the sample-and-hold circuit 11. The peak value detector 10 is reset while the sample-and-hold circuit 11 reads the peak value. The control word emitted by the circuit 6 is thus determined by the highest filling degree in each period for the multiframe reference signal. This provides for a more stable adjustment.

Although a preferred embodiment of the present invention has been described and shown, the invention is not restricted to it, but may also be embodied in other ways within the scope of the subject-matter defined in the appended claims.

## Claims

1. A digital phase-locked loop comprising a numerically controlled oscillator (5) which is adapted to generate a clock signal by dividing a system clock frequency by a factor determined by a control word, and a phase detector (2; 3) which is adapted to generate said control word in response to a phase difference between said clock signal and an external reference signal, so that the control word assumes a nominal value when said phase difference is numerically smaller than a value given in advance, and may assume one or more other values when the phase difference is numerically greater than the given value, **characterized in that** the loop moreover comprises means (7) which, when the phase difference is numerically greater than the given value, are capable of modulating the control word, so that said word assumes one of the one or more other values in subperiods, while it assumes the nominal value in intermediate periods.

2. A digital phase-locked loop according to claim 1, **characterized in that**, in addition to the nominal value (0), the control word may assume at least one other value (+1) when the phase difference indicates that the clock signal frequency is lower than the reference signal frequency, and at least one other value (-1) when the clock signal frequency is higher than the reference signal frequency.

3. A digital phase-locked loop according to claim 2, **characterized in that** the control word may assume two values (+1, +2) when the phase difference indicates that the clock signal frequency is lower than the reference signal frequency, and two values (-1, -2) when the clock signal frequency is higher than the reference signal frequency, and that said modulation means (7) are adapted to modulate the control word only when it assumes the values (+1, -1) which correspond to the numerically smallest phase difference.

4. A digital phase-locked loop according to claims 1-3, **characterized in that** said modulation means (7) are adapted to modulate the control word with a pulse signal which has a fixed cycle time and a variable pulse width.

5. A digital phase-locked loop according to claim 4, **characterized in that** it moreover comprises means (9) for controlling the pulse width in response to said phase difference.

6. A method of controlling a digital phase-locked loop, wherein a clock signal is generated by dividing a system clock frequency by a factor determined by a control word, and wherein said control word is generated in response to phase difference between said clock signal and an external reference signal, so that the control word assumes a nominal value when said phase difference is numerically smaller than a value given in advance, and may assume one or more other values when the phase difference is numerically greater than the given value,
**characterized in that** when the phase difference is numerically greater than the given value, the control word is modulated so that it assumes one of the one or more other values in subperiods, while it assumes the nominal value in intermediate periods.

7. A method of desynchronization in a receiver in a digital transmission system, wherein justification is performed by adding or removing, as needed, one or more bits in the transmitted bit flow on the transmission side when placing e.g. telephone calls in the transmission system, and wherein the effect of the added or removed bits is smoothed in the receiver in the desynchronization,
and wherein a clock signal is generated in a digital phase-locked loop in the receiver by dividing a system clock frequency by a factor determined by a control word, which is generated in response to a phase difference between said clock signal and an external reference signal, so that the control word assumes a nominal value when said phase difference is numerically smaller than a value given in advance, and may assume one or more other values when the phase difference is numerically greater than the given value,
**characterized in that** when the phase difference is numerically greater than the given value, the control word is modulated so that it assumes one of the one or more other values in subperiods, while it assumes the nominal value in intermediate periods.

8. A receiver circuit for use in a digital transmission system and adapted to receive and desynchronize data signals in the form of a bit flow, wherein justification is performed by adding or removing, as needed, one or more bits in the transmitted bit flow on the transmission side when placing e.g. telephone calls in the transmission system, and wherein the receiver circuit is moreover adapted to smooth the effect of the added and removed bits in the desynchronization,
and wherein the receiver circuit comprises a digital phase-locked loop having a numerically controlled oscillator (5) which is adapted to generate a clock signal by dividing a system clock frequency by a factor determined by a control word, and a phase detector (2; 3) which is adapted to generate said control word in response to a phase difference between said clock signal and a reference clock signal derived from the data signals received, so that the control word assumes a nominal value when said phase difference is numerically smaller than a value given in advance, and may assume one or more other values when the phase difference is numerically greater than the given value,
**characterized in that** the digital phase-locked loop moreover comprises means (7) which, when the phase difference is numerically greater than the given value, may modulate the control word so that it assumes one of the one or more other values in subperiods, while it assumes the nominal value in intermediate periods.

9. A receiver circuit according to claim 8, **characterized in that** it comprises a buffer circuit (2) adapted such that the received data signals may be input in the buffer circuit by means of the reference clock signal and be output again by means of said clock signal, and that the phase detector of the digital phase-locked loop is formed by the buffer circuit (2), the number of data signals input in but not yet output from the buffer circuit (2) being used as an indication of the phase difference between said clock signal and the reference clock signal.

10. A receiver circuit according to claim 9, **characterized in that** the buffer circuit (2) is constructed as a ring buffer and is capable of storing 12 bytes.

11. A receiver circuit according to claim 9 or 10, **characterized in that**, in addition to the nominal value (0), the control word may assume at least one other value (+1) when the phase difference indicates that the clock signal frequency is lower than the reference clock signal frequency, and at least one other value (-1) when the clock signal frequency is higher than the reference clock signal frequency.

12. A receiver circuit according to claim 11, **characterized in that** the control word may assume two values (+1, +2) when the phase difference indicates that the clock signal frequency is lower than the reference clock signal frequency, and two values (-1, -2) when the clock signal frequency is higher than the reference clock signal frequency, and that said modulation means (7) are adapted to modulate the control word only when it assumes the values (+1, -1) which correspond to the numerically smallest phase difference.

13. A receiver circuit according to claims 8-12, **characterized in that** said modulation means (7) are adapted to modulate the control word with a pulse signal which has a fixed cycle time and a variable pulse width.

14. A receiver circuit according to claim 13, **characterized in that** it moreover comprises means (9) to control the pulse width in response to said phase difference.

15. A receiver circuit according to claim 9, **characterized in that** it comprises means (10, 11) to generate the control word in response to a highest value of the number of data signals which are input but not yet output from the buffer circuit (2), measured over a period of time.

16. A receiver circuit according to claims 8-15, **characterized in that** the numerically controlled oscillator (5) is adapted to generate a clock signal whose nominal frequency is 2.112 MHz.

## Patentansprüche

1. Digitale Phasenregelschleife, umfassend einen numerisch gesteuerten Oszillator (5), der so angepasst ist, dass er ein Taktsignal erzeugt, indem er eine Systemtaktfrequenz durch einen Faktor, der durch ein Steuerwort bestimmt ist, dividiert, und einen Phasendiskriminator (2; 3), der so angepasst ist, dass er das Steuerwort ansprechend auf einen Phasenunterschied zwischen dem Taktsignal und einem externen Bezugssignal erzeugt, so dass das Steuerwort einen Nennwert annimmt, wenn der Phasenunterschied zahlenmäßig kleiner ist als ein im voraus gegebener Wert, und einen oder mehrere andere Werte annehmen kann, wenn der Phasenunterschied zahlenmäßig größer ist als der gegebene Wert,
**dadurch gekennzeichnet, dass** die Schleife außerdem Einrichtungen (7) umfasst, die, wenn der Phasenunterschied zahlenmäßig größer ist als der gegebene Wert, das Steuerwort modulieren können, so dass das Wort einen von dem einen oder mehreren anderen Werten in Subperioden annimmt, während es den Nennwert in Zwischenperioden annimmt.

2. Digitale Phasenregelschleife nach Anspruch 1, **dadurch gekennzeichnet, dass** das Steuerwort zusätzlich zum Nennwert (0) mindestens einen anderen Wert (+1) annehmen kann, wenn der Phasenunterschied anzeigt, dass die Taktsignalfrequenz niedriger ist als die Bezugssignalfrequenz, und mindestens einen anderen Wert (-1), wenn die Taktsignalfrequenz höher ist als die Bezugssignalfrequenz.

3. Digitale Phasenregelschleife nach Anspruch 2, **dadurch gekennzeichnet, dass** das Steuerwort zwei Werte (+1, +2) annehmen kann, wenn der Phasenunterschied anzeigt, dass die Taktsignalfrequenz niedriger ist als die Bezugssignalfrequenz, und zwei Werte (-1, -2), wenn die Taktsignalfrequenz höher ist als die Bezugssignalfrequenz, und dass die Modulationseinrichtungen (7) so angepasst sind, dass sie das Steuerwort nur modulieren, wenn es die Werte (+1, -1) annimmt, die dem zahlenmäßig kleinsten Phasenunterschied entsprechen.

4. Digitale Phasenregelschleife nach den Ansprüchen 1-3, **dadurch gekennzeichnet, dass** die Modulationseinrichtungen (7) so angepasst sind, dass sie das Steuerwort mit einem Impulssignal modulieren, das eine feste Zykluszeit und eine variable Impulsbreite aufweist.

5. Digitale Phasenregelschleife nach Anspruch 4, **dadurch gekennzeichnet, dass** sie außerdem eine Einrichtung (9) zum Steuern der Impulsbreite ansprechend auf den Phasenunterschied umfasst.

6. Verfahren zum Steuern einer digitalen Phasenregelschleife, bei dem ein Taktsignal erzeugt wird, indem eine Systemtaktfrequenz durch einen Faktor, der durch ein Steuerwort bestimmt ist, dividiert wird, und bei dem das Steuerwort ansprechend auf einen Phasenunterschied zwischen dem Taktsignal und einem externen Bezugssignal erzeugt wird, so dass das Steuerwort einen Nennwert annimmt, wenn der Phasenunterschied zahlenmäßig kleiner ist als ein im voraus gegebener Wert, und einen oder mehrere andere Werte annehmen kann, wenn der Phasenunterschied zahlenmäßig größer ist als der gegebene Wert,
**dadurch gekennzeichnet, dass**, wenn der Phasenunterschied zahlenmäßig größer ist als der gegebene Wert, das Steuerwort so moduliert wird, dass es einen von dem einen oder mehreren anderen Werten in Subperioden annimmt, während es den Nennwert in Zwischenperioden annimmt.

7. Verfahren zur Desynchronisation in einem Empfänger in einem digitalen Übertragungssystem, bei dem nach Bedarf ein Stopfen durch Hinzufügen oder Entfernen von einem oder mehreren Bits im übertragenen Bitstrom auf der Übertragungsseite ausgeführt wird, wenn z.B. Telefonanrufe in dem Übertragungssystem platziert werden, und bei dem die Auswirkung der hinzugefügten oder entfernten Bits im Empfänger bei der Desynchronisation geglättet wird,
und bei dem ein Taktsignal in einer digitalen Phasenregelschleife im Empfänger erzeugt wird, indem eine Systemtaktfrequenz durch einen Faktor, der durch ein Steuerwort bestimmt ist, dividiert wird, das ansprechend auf einen Phasenunterschied zwischen dem Taktsignal und einem externen Bezugssignal erzeugt wird, so dass das Steuerwort einen Nennwert annimmt, wenn der Phasenunterschied zahlenmäßig kleiner ist als ein im voraus gegebener Wert, und einen oder mehrere andere Werte annehmen kann, wenn der Phasenunterschied zahlenmäßig größer ist als der gegebene Wert,
**dadurch gekennzeichnet, dass**, wenn der Phasenunterschied zahlenmäßig größer ist als der gegebene Wert, das Steuerwort so moduliert wird, dass es einen von dem einen oder mehreren anderen Werten in Subperioden annimmt, während es den Nennwert in Zwischenperioden annimmt.

8. Empfängerschaltung zur Verwendung in einem digitalen Übertragungssystem und angepasst, um Datensignale in Form eines Bitstroms zu empfangen und desynchronisieren, bei der nach Bedarf ein Stopfen durch Hinzufügen oder Entfernen von einem oder mehreren Bits im übertragenen Bitstrom auf der Übertragungsseite ausgeführt wird, wenn z.B. Telefonanrufe im Übertragungssystem platziert werden, und bei der die Empfängerschaltung außerdem so angepasst ist, dass sie die Auswirkung der hinzugefügten und entfernten Bits bei der Desynchronisation glättet,
und wobei die Empfängerschaltung umfasst: eine digitale Phasenregelschleife mit einem numerisch gesteuerten Oszillator (5), der so angepasst ist, dass er ein Taktsignal erzeugt, indem eine Systemtaktfrequenz durch einen Faktor, der durch ein Steuerwort bestimmt ist, dividiert, und einen Phasendiskriminator (2; 3), der so angepasst ist, dass er das Steuerwort ansprechend auf einen Phasenunterschied zwischen dem Taktsignal und einem Bezugstaktsignal, das von den empfangenen Datensignalen hergeleitet ist, erzeugt, so dass das Steuerwort einen Nennwert annimmt, wenn der Phasenunterschied zahlenmäßig kleiner ist als ein im voraus gegebener Wert, und einen oder mehrere andere Werte annehmen kann, wenn der Phasenunterschied zahlenmäßig größer ist als der gegebene Wert,
**dadurch gekennzeichnet, dass** die digitale Phasenregelschleife außerdem Einrichtungen (7) umfasst, die, wenn der Phasenunterschied zahlenmäßig größer ist als der gegebene Wert, das Steuerwort modulieren können, so dass es einen von dem einen oder mehreren anderen Werten in Subperioden annimmt, während es den Nennwert in Zwischenperioden annimmt.

9. Empfängerschaltung nach Anspruch 8, **dadurch gekennzeichnet, dass** sie eine Pufferschaltung (2) umfasst, die so angepasst ist, dass die empfangenen Datensignale in die Pufferschaltung mittels des Bezugstaktsignals eingegeben und mittels des Taktsignals wieder ausgegeben werden können, und dass der Phasendiskriminator der digitalen Phasenregelschleife durch die Pufferschaltung (2) gebildet wird, wobei die Anzahl von Datensignalen, die in die Pufferschaltung (2) eingegeben aber noch nicht aus ihr ausgegeben sind, als Anzeige des Phasenunterschieds zwischen dem Taktsignal und dem Bezugstaktsignal verwendet werden.

10. Empfängerschaltung nach Anspruch 9, **dadurch gekennzeichnet, dass** die Pufferschaltung (2) als Ringpuffer konstruiert ist und 12 Bytes speichern kann.

11. Empfängerschaltung nach Anspruch 9 oder 10, **dadurch gekennzeichnet, dass** das Steuerwort zusätzlich zum Nennwert (0) mindestens einen anderen Wert (+1) annehmen kann, wenn der Phasenunterschied anzeigt, dass die Taktsignalfrequenz niedriger ist als die Bezugstaktsignalfrequenz, und mindestens einen anderen Wert (-1), wenn die Taktsignalfrequenz höher ist als die Bezugstaktsignalfrequenz.

12. Empfängerschaltung nach Anspruch 11, **dadurch gekennzeichnet, dass** das Steuerwort zwei Werte (+1, +2) annehmen kann, wenn der Phasenunterschied anzeigt, dass die Taktsignalfrequenz niedriger ist als die Bezugst'aktsignalfrequenz, und zwei Werte (-1, -2), wenn die Taktsignalfrequenz höher ist als die Bezugstaktsignalfrequenz, und dass die Modulationseinrichtungen (7) so angepasst sind, dass sie das Steuerwort nur modulieren, wenn es die Werte (+1, -1) annimmt, die dem zahlenmäßig kleinsten Phasenunterschied entsprechen.

13. Empfängerschaltung nach den Ansprüchen 8-12, **dadurch gekennzeichnet, dass** die Modulationseinrichtungen (7) so angepasst sind, dass sie das Steuerwort mit einem Impulssignal modulieren, das eine feste Zykluszeit und eine variable Impulsbreite aufweist.

14. Empfängerschaltung nach Anspruch 13, **dadurch gekennzeichnet, dass** sie außerdem eine Einrichtung (9) umfasst, um die Impulsbreite ansprechend auf den Phasenunterschied zu steuern.

15. Empfängerschaltung nach Anspruch 9, **dadurch gekennzeichnet, dass** sie Einrichtungen (10, 11) umfasst, um das Steuerwort ansprechend auf einen höchsten Wert der Anzahl von Datensignalen, die eingegeben aber noch nicht aus der Pufferschaltung (2) ausgegeben sind, zu erzeugen, gemessen über eine Zeitspanne.

16. Empfängerschaltung nach den Ansprüchen 8-15, **dadurch gekennzeichnet, dass** der numerisch gesteuerte Oszillator (5) so angepasst ist, dass er ein Taktsignal erzeugt, dessen Nennfrequenz 2,112 MHz beträgt.

## Revendications

1. Boucle à verrouillage de phase numérique comprenant un oscillateur commandé de façon numérique (5), adapté à produire un signal d'horloge en divisant la fréquence d'une horloge système par un facteur déterminé par un mot de commande et un détecteur de phase (2; 3), adapté à produire ledit mot de commande en réponse à la différence de phase entre ledit signal d'horloge et un signal de référence externe, de telle sorte que le mot de commande prenne une valeur nominale lorsque ladite différence de phase est numériquement plus petite qu'une valeur donnée à l'avance et puisse prendre une ou plusieurs autres valeurs lorsque la différence de phase est numériquement plus grande que la valeur donnée,
**caractérisé en ce que** la boucle comprend, de plus, des moyens (7) qui, lorsque la différence de phase est numériquement plus grande que la valeur donnée, sont capables de moduler le mot de commande, de telle sorte que ledit mot prenne une parmi la ou les autres valeurs dans des sous-périodes, tout en prenant la valeur nominale dans les périodes intermédiaires.

2. Boucle à verrouillage de phase numérique selon la revendication 1, **caractérisée en ce que**, outre la valeur nominale (0), le mot de commande peut prendre au moins une autre valeur (+1) lorsque la différence de phase indique que la fréquence du signal d'horloge est inférieure à la fréquence du signal de référence et au moins une autre valeur (-1) lorsque la fréquence du signal d'horloge est supérieure à la fréquence du signal de référence.

3. Boucle à verrouillage de phase numérique selon la revendication 2, **caractérisée en ce que** le mot de commande peut prendre deux valeurs (+1, +2) lorsque la différence de phase indique que la fréquence du signal d'horloge est inférieure à la fréquence du signal de référence et deux valeurs (-1, -2) lorsque la fréquence du signal d'horloge est supérieure à la fréquence du signal de référence et **en ce que** lesdits moyens de modulation (7) sont adaptés à moduler le mot de commande seulement lorsqu'il prend les valeurs (+1, -1) qui correspondent à la différence de phase numériquement la plus petite.

4. Boucle à verrouillage de phase numérique selon les revendications 1 à 3, **caractérisée en ce que** lesdits moyens de modulation (7) sont adaptés à moduler le mot de commande avec un signal impulsionnel ayant un temps de cycle fixe et une largeur d'impulsions variable.

5. Boucle à verrouillage de phase numérique selon la revendication 4, **caractérisée en ce qu'**elle comprend de plus, un moyen (9) pour commander la largeur des impulsions en réponse à ladite différence de phase.

6. Procédé de commande d'une boucle à verrouillage de phase numérique, dans lequel un signal d'horloge est produit en divisant la fréquence d'une horloge système par un facteur déterminé par un mot de commande et dans lequel ledit mot de commande est produit en réponse à la différence de phase entre ledit signal d'horloge et un signal de référence externe, de telle sorte que le mot de commande prenne une valeur nominale lorsque ladite différence de phase est numériquement plus petite qu'une valeur donnée à l'avance et puisse prendre une ou plusieurs autres valeurs lorsque la différence de phase est numériquement plus grande que la valeur donnée,
**caractérisé en ce que**, lorsque la différence de phase est numériquement plus grande que la valeur donnée, le mot de commande est modulé de telle sorte qu'il prenne une parmi la ou les autres valeurs dans des sous-périodes, tout en prenant la valeur nominale dans les périodes intermédiaires.

7. Procédé de désynchronisation dans un récepteur d'un système de transmission numérique, dans lequel une justification est effectuée en ajoutant ou en retirant, comme nécessaire, un ou plusieurs bits dans le courant de bits transmis du côté émission en effectuant, par exemple, des appels téléphoniques dans le système de transmission et dans lequel l'effet des bits ajoutés ou retirés est régularisé dans le récepteur lors de la désynchronisation,
et dans lequel un signal d'horloge est produit dans une boucle à verrouillage de phase numérique du récepteur en divisant la fréquence d'une horloge système par un facteur déterminé par un mot de commande qui est produit en réponse à la différence de phase entre ledit signal d'horloge et un signal de référence externe, de telle sorte que le mot de commande prenne une valeur nominale lorsque ladite différence de phase est numériquement plus petite qu'une valeur donnée à l'avance et puisse prendre une ou plusieurs autres valeurs lorsque la différence de phase est numériquement plus grande que la valeur donnée,
**caractérisé en ce que**, lorsque la différence de phase est numériquement plus grande que la valeur donnée, le mot de commande est modulé de telle sorte qu'il prenne une parmi la ou les autres valeurs dans des sous-périodes, tout en prenant la valeur nominale dans les périodes intermédiaires.

8. Circuit récepteur destiné à être utilisé dans un système de transmission numérique et adapté à recevoir et à désynchroniser des signaux de données sous la forme d'un courant de bits, dans lequel une justification est effectuée en ajoutant ou en retirant, comme nécessaire, un ou plusieurs bits dans le courant de bits transmis du côté émission en effectuant, par exemple, des appels téléphoniques dans le système de transmission et dans lequel le circuit récepteur est, de plus, adapté à régulariser l'effet des bits ajoutés ou retirés lors de la désynchronisation,
et dans lequel le circuit récepteur comprend une boucle à verrouillage de phase numérique comportant un oscillateur commandé de façon numérique (5), adapté à produire un signal d'horloge en divisant la fréquence d'une horloge système par un facteur déterminé par un mot de commande et un détecteur de phase (2; 3), adapté à produire ledit mot de commande en réponse à la différence de phase entre ledit signal d'horloge et un signal d'horloge de référence dérivé des signaux de données reçus, de telle sorte que le mot de commande prenne une valeur nominale lorsque ladite différence de phase est numériquement plus petite qu'une valeur donnée à l'avance et puisse prendre une ou plusieurs autres valeurs lorsque la différence de phase est numériquement plus grande que la valeur donnée,
**caractérisé en ce que** la boucle à verrouillage de phase numérique comprend, de plus, un moyen (7) qui, lorsque la différence de phase est numériquement plus grande que la valeur donnée, peut moduler le mot de commande de telle sorte qu'il prenne une parmi la ou les autres valeurs dans des sous-périodes, tout en prenant la valeur nominale dans les périodes intermédiaires.

9. Circuit récepteur selon la revendication 8, **caractérisé en ce qu'**il comprend un circuit tampon (2) adapté de telle sorte que les signaux de données reçus puissent être appliqués à l'entrée du circuit tampon au moyen du signal d'horloge de référence et puissent de nouveau être fournis en sortie au moyen dudit signal d'horloge et **en ce que** le détecteur de phase de la boucle à verrouillage de phase numérique est constitué par le circuit tampon (2), le nombre de signaux de données appliqués en entrée mais pas encore fournis en sortie du circuit tampon (2) étant utilisé comme indication de la différence de phase entre ledit signal d'horloge et le signal d'horloge de référence.

10. Circuit récepteur selon la revendication 9, **caractérisé en ce que** le circuit tampon (2) est construit sous la forme d'un tampon en anneau et est capable de mémoriser 12 octets.

11. Circuit récepteur selon la revendication 9 ou 10, **caractérisé en ce que**, outre la valeur nominale (0), le mot de commande peut prendre au moins une autre valeur (+1) lorsque la différence de phase indique que la fréquence du signal d'horloge est inférieure à la fréquence du signal d'horloge de référence et au moins une autre valeur (-1) lorsque la fréquence du signal d'horloge est supérieure à la fréquence du signal d'horloge de référence.

12. Circuit récepteur selon la revendication 11, **caractérisé en ce que** le mot de commande peut prendre deux valeurs (+1, +2) lorsque la différence de phase indique que la fréquence du signal d'horloge est inférieure à la fréquence du signal d'horloge de référence et deux valeurs (-1, -2) lorsque la fréquence du signal d'horloge est supérieure à la fréquence du signal d'horloge de référence et **en ce que** lesdits moyens de modulation (7) sont adaptés à moduler le mot de commande seulement lorsqu'il prend les valeurs (+1, -1) qui correspondent à la différence de phase numériquement la plus petite.

13. Circuit récepteur selon les revendications 8 à 12, **caractérisé en ce que** lesdits moyens de modulation (7) sont adaptés à moduler le mot de commande avec un signal impulsionnel ayant un temps de cycle fixe et une largeur d'impulsions variable.

14. Circuit récepteur selon la revendication 13, **caractérisé en ce qu'**il comprend de plus, un moyen (9) pour commander la largeur des impulsions en réponse à ladite différence de phase.

15. Circuit récepteur selon la revendication 9, **caractérisé en ce qu'**il comprend un moyen (10, 11) pour produire le mot de commande en réponse à la plus grande valeur du nombre de signaux de données qui sont appliquées en entrée mais pas encore fournis en sortie du circuit tampon (2), mesurée pendant une certaine période de temps.

16. Circuit récepteur selon les revendications 8 à 15, **caractérisé en ce que** l'oscillateur commandé de façon numérique (5) est adapté à fournir un signal d'horloge dans la fréquence nominale est de 2,112 MHz.
